# EUROPÄISCHE PATENTSCHRIFT

(11) **EP 1 756 863 B1**
(45) Veröffentlichungstag und Bekanntmachung des Hinweises auf die Patenterteilung: **05.01.2011**
(21) Anmeldenummer: 05750515.8
(22) Anmeldetag: 06.05.2005
(51) Int. Cl.: H01L 21/762

(54) **SOI-SCHEIBEN MIT MEMS-STRUKTUREN UND VERFUELLTEN ISOLATIONSGRAEBEN MIT DEFINIERTEM QUERSCHNITT**
SOI DISKS COMPRISING MEMS STRUCTURES AND FILLED ISOLATING TRENCHES HAVING A DEFINED CROSS-SECTION
TRANCHES DE SOI COMPRENANT DES STRUCTURES MEMS ET DES TRANCHEES D'ISOLATION REMPLIES DE SECTION TRANSVERSALE DEFINIE

(30) Priorität: 08.05.2004 DE 102004022781
(43) Veröffentlichungstag der Anmeldung: 28.02.2007
(73) Patentinhaber: X-FAB Semiconductor Foundries AG, 99097 Erfurt (DE)
(72) Erfinder: FREYWALD, Karlheinz, X-FAB Semicond. Foundries AG, 99097 Erfurt (DE); HOELZER, Gisbert,X-FAB Semiconductor Foundries AG, 99097 Erfurt (DE)
(74) Vertreter: Leonhard, Frank Reimund
(86) Internationale Anmeldenummer: PCT/DE2005/000855
(87) Internationale Veröffentlichungsnummer: WO 2005/112109

(56) Entgegenhaltungen:
- WO-A-02/103772
- DE-A1- 19 751 740
- DE-C1- 10 137 370
- US-A- 4 533 430
- US-B1- 6 380 037

## Beschreibung

Die Erfindung betrifft eine Isolationsgrabenstruktur (Anspruch 1) und eine Herstellung von verfüllten Isolationsgrabenstrukturen (Anspruch 11) zur di-elektrischen Isolation von Gebieten der aktiven Siliziumschicht aus SOI-Scheiben (Silizium auf Isolator Scheiben) mit MEMS Strukturen und Schaltungseinheiten, wobei die verfüllten IsolationsgrabenStrukturen auch zumindest teilweise an und/oder innerhalb der Vertiefung bzw. Gruben mit der aktiven Sensorstruktur ausgebildet sind.

Ein breites Einsatzgebiet von verfüllten Isolationsgräben ist die dielektrische Isolierung von CMOS-Schaltungen auf Basis von SOI-Scheiben. Im Patent US-A 6,229,194 wird eine solche Anwendung beschrieben. Da hier keine MEMS-Elemente mit einer Grube mit aktiver Sensorstruktur realisiert werden sollen, lassen sich die verfüllten Isolationsgräben zur dielektrischen Isolierung als geschlossene Polygone ausbilden, so dass die verfüllten Isolationsgräben nicht in von siliziumfreien Gebieten, d. h. in Vertiefungen, enden.

Des weiteren werden im Stand der Technik verfüllte Isolationsgräben für integrierte Schaltungen in einkristallinem Silizium realisiert (siehe 2003 001 5764 A1) und diese können zur platzsparenden Trennung von Diffusionsgebieten eingesetzt werden. Dabei ist es nicht unbedingt erforderlich, einen geschlossenen Polygonzug zu realisieren, da keine absolute dielektrische Isolierung erreicht werden kann.

Im Patent US-A 5,448,102 wird ein Verfahren zur Stressreduzierung in Verbindung mit verfüllten Isolationsgräben beschrieben, das sowohl für einkristalline Si-Scheiben als auch für SOI-Scheiben angewendet wird. In dieser Anwendung werden nur Isolationsgräben, die eine Form geschlossener Polygone aufweisen, eingesetzt. Isolationsgräben, die in Vertiefungen bzw. Gruben enden, wie sie bei MEMS-Strukturen tragenden SOI-Halbleiterstrukturen häufig anzutreffen sind, werden, wie schon in den vorhergehenden Schriften, auch in dieser Schrift nicht gezeigt.

In verschiedenen MEMS-Technologien auf Basis von SOI-Scheiben wird die Vertiefung bzw. die Grube mit der aktiven Sensorstruktur zusammen mit den Isolationsgräben in einem einzigen Ätzschritt hergestellt, wie dies in US-A 6,117,701 beschrieben ist. In diesem Falle ist eine Füllung des Grabens nicht möglich, da ansonsten auch die Sensorstruktur gefüllt werden würde.

WO 02/103772 zeigt die Ausbildung diverser Isolationsgräben in einem Halbleitersubstrat, wobei zwar unterschiedliche Formen beschrieben sind, jedoch die Verwendung derartiger Isolationsgräben für SOI-Bauelemente nicht in Erwägung gezogen wird.

DE 101 37 370 zeigt ein Verfahren zur Herstellung von Seitenwandabstandhaltern in einem Graben, wobei die Dicke der Abstandshalter sich nach unten hin vergrößert.

US 4 533 430zeigt ein Verfahren zur Herstellung eines Grabens, wobei das Gebiet in der Nähe der Grabenöffnung beschichtet wird, um eine möglichst steile Seitenwand oder eine Ausbauchung zu vermeiden.

**Aufgabe der Erfindung** ist es daher, eine Technik anzugeben, in der sich gefüllte Isolationsstrukturen zur Isolierung von Halbleitergebieten verwirklichen lassen, die auch eine ausreichend hohe Isolationsfestigkeit besitzen, wenn die Isolationsstrukturen in Vertiefungen enden oder durch diese hindurch laufen, in denen Sensorstrukturen vorzusehen sind.

Erfindungsgemäß wird diese Aufgabe in einem Aspekt der vorliegenden Erfindung durch eine SOI-Halbleiterstruktur gelöst, wobei die Struktur ein erstes Gebiet und ein zweites Gebiet und eine Isolationsstruktur aufweist, die zwischen dem ersten und dem zweiten Gebiet als Isolationsgraben zur elektrischen Isolierung des ersten Gebiets von dem zweiten Gebiet ausgebildet ist. Ferner ist die Isolationsstruktur so ausgebildet, dass diese zumindest lateral abschnittsweise nach unten hin verbreitert ist.

Die Erfindung betrifft somit die Gestaltung von verfüllten Isolationsgräben, wobei die erfindungsgemäße SOI-Halbleiterstruktur als Ausgangsbasis dienen kann, um damit insbesondere Übergangsbereiche in von Silizium freien Bereichen (Gruben bzw. Vertiefungen) bei der Realisierung von MEMS-Strukturen in Verbindung mit Schaltungseinheiten auf SOI-Scheiben ausreichend zu isolieren für den Fall, dass die Isolationsstruktur in der Grube bzw. der Vertiefung, in der eine aktive Sensorstruktur auszubilden ist, vorhanden ist bzw. dort endet oder diese Vertiefung durchläuft. Die Isolationsstruktur hat die Aufgabe, benachbarte Siliziumgebiete einer derartigen MEMS-Struktur dielektrisch voneinander zu isolieren. Hierbei stellt die in einer zu bildenden Vertiefung endende verfüllte Isolationsstruktur eine Besonderheit dar. Im Bereich der Vertiefung bzw. der Grube, die zur Aufnahme der aktiven Sensorstruktur dient, wird die Isolationsstruktur auf einem entsprechenden kurzen Stück vom umliegenden Silizium frei geätzt. Um ein hohes Maß an Isolierung zu erreichen, ist es hierbei wichtig, das umgebende Silizium möglichst vollständig zu entfernen, um eine mögliche leitende Verbindung in Form nicht vollständig entfernter, leitender Siliziumgebieten, insbesondere in Form dünner Streifen, zu verhindern.

Dieses Ziel wird durch die erfindungsgemäße Formgebung der Isolationsstruktur erreicht. Somit kann eine (praktisch) vollständige Isolierung von benachbarten Siliziumgebieten in lateraler Richtung durch die entsprechende Gestaltung der Isolationsstrukturen oder zumindest deren Endbereiche, die benachbart zu von Silizium freien Gebieten angeordnet sind, bei der Realisierung von MEMS-Strukturen auf SOI-Scheiben in Verbindung mit Schaltungsstrukturen erreicht werden.

Die erfindungsgemäße SOI-Halbleiterstruktur ermöglicht somit, dass beim Übergang der Isolationsstruktur in die Vertiefung bzw. Grube diese im Gegensatz zur Verwendung bisher bekannter Isoliergrabentechnologien vollständig freigelegt wird. Bei bekannten Isoliergrabentechnologien besteht der Nachteil, dass im Fußbereich der freigelegten Grabenverfüllung bzw. Isolationsstruktur an deren Wand ein mehr oder weniger breiter leitfähiger Siliziumstreifen stehen bleibt, so dass eine leitfähige Verbindung zwischen den benachbarten und zu isolierenden Siliziumgebieten kaum verhindert werden kann.

Die erfindungsgemäße SOI-Halbleiterstruktur weist die Vorteile auf, dass diese für die Herstellung von MEMS-Strukturen eingesetzt werden kann, ohne dass zusätzliche Verfahrensschritte bei der Bauelementeherstellung eingeführt werden müssen. Die besondere Geometrie der Isolationsstruktur, die durch ein entsprechendes Rezept bei der Siliziumätzung erreicht wird, verbessert das Ätzverhalten bei einer nachfolgenden Siliziumätzung, in der eine Vertiefung in der Siliziumschicht herzustellen ist, wobei zumindest ein Teil der Isolationsstruktur von dem Ätzprozess betroffen ist und auf Grund der sich nach unten hin verbreitenden Geometrie ein verbessertes Ätzverhalten auch am Fußbereich der Isolationsstruktur bietet, so dass das Silizium im Wesentlichen vollständig entfernt werden kann. D. h., auf Grund der sich nach unten verbreiternden Form, die als A-Form bezeichnet werden kann, kann somit das Auftreten unerwünschter leitfähiger Siliziumstreifen im Wesentlichen verhindert werden, da die Schräge der Seitenwand der Isolationsstruktur den Ätzangriff an der Seitenwand verbessert, wenn das Silizium selektiv zur Isolationsstruktur bei der Ausbildung einer Grube bzw. Vertiefung geätzt wird.

In einer weiteren Ausführungsform endet die Isolationsstruktur in der Vertiefung, reicht in diese hinein oder durchläuft diese. Auf Grund der erfindungsgemäßen Isolationsgrabengeometrie lassen sich beliebige gewünschte Anordnungen der Isolationsstruktur innerhalb der gebildeten Vertiefung realisieren, ohne dass Beeinträchtigungen hinsichtlich der Isolationsfestigkeit auf Grund von Siliziumresten auftreten.

In einer weiteren Ausbildung verbreitert sich die Isolationsstruktur nach unten hin in stetiger Weise. Diese stetige Vergrößerung der Isolationsstrukturbreite kann durch geeignete Ätzverfahren bei der Herstellung eines entsprechenden Grabens in der aktiven Siliziumschicht erreicht werden.

In einer weiteren vorteilhaften Ausführung ist die Isolationsstruktur so mit einem dielektrischen Material gefüllt, dass zumindest in Bereichen der Isolationsstruktur ein Hohlraum im Inneren der Isolationsstruktur gebildet ist. Diese Hohlraumbildung, die zur Verminderung von mechanischen Spannungen innerhalb der Grabenstruktur dienen kann, ist insbesondere bei MEMS-Anwendungen von großer Bedeutung, so dass sich insgesamt ein besseres Bauteilverhalten erreichen lässt. Die Erzeugung von Hohlräumen innerhalb der Isolationsstruktur lässt sich auf Grund der erfindungsgemäßen Isolationsstrukturgeometrie in besonders wirksamer Weise auf der Grundlage gut etablierter Abscheidetechniken, beispielsweise plasma-unterstützter CVD (chemische Dampfabscheidung) verwirklichen, da die sich nach unten öffnende Grabenbreite bei der Abscheidung ein vorzeitiges Schließen der Grabenöffnung bewirkt und damit die Entstehung eines entsprechenden Hohlraums fördert.

In weiteren vorteilhaften Ausführungen reicht ein Teil mit definierter Länge der Isolationsstruktur in die Vertiefung hinein, wobei der Teil der Isolationsstruktur geradlinig oder über Eck oder mäanderförmig in der Vertiefung verlaufen kann. Somit sind nahezu beliebige geometrische Konfigurationen der Isolationsstruktur innerhalb der für die Aufnahme von aktiven Sensorelementen gedachten Vertiefungen bzw. Gruben verwirklichbar, ohne dass die Isolationseigenschaft beeinträchtigt wird.

In einer weiteren vorteilhaften Ausführung ist die Isolationsstruktur mit Ausnahme von Hohlräumen, die darin ausgebildet sein können, im Wesentlichen ausschließlich aus Siliziumdioxid gebildet. Auf Grund der äußerst günstigen Eigenschaften von Siliziumdioxid in Verbindung mit Silizium, d. h. beispielsweise die ausgeprägte Ätzselektivität dieser beider Materialien in Bezug auf gut etablierte anisotrope Ätzrezepte, die hohe thermische Stabilität der Grenzfläche zwischen Silizium und Siliziumdioxid, und dergleichen ermöglichen die Herstellung sehr zuverlässiger Isolationsstrukturen in SOI-MEMS-Strukturen.

In einer weiteren vorteilhaften Ausführung ist die Isolationsstruktur lediglich in der von Silizium freigeätzten Vertiefung mit einer nach unten sich verbreiternden Geometrie versehen. Auf diese Weise können in Bereichen der aktiven Siliziumschicht, die nicht in der Nähe der Vertiefung liegen, konventionelle Isolationsgrabentechnologien eingesetzt werden, ohne dass damit jedoch die Isolationsfestigkeit in den Vertiefungen beeinträchtigt wird.

Gemäß einem weiteren Aspekt der vorliegenden Erfindung wird die obige Aufgabe durch ein Verfahren zum Ätzen einer Vertiefung in eine aktive Siliziumschicht eines SOI-Substrats gelöst. Das Verfahren umfasst die Schritte des Vorsehens eines Isolationsgrabens in der aktiven Siliziumschicht, der sich bis zu einer vergrabenen Isolationsschicht erstreckt und der zumindest im Bereich der zu bildenden Vertiefung nach unten hin verbreitert ist. Ferner umfasst das Verfahren den Schritt des selektiven anisotropen Ätzens des Siliziums bis zu der vergrabenen Isolationsschicht, um die Vertiefung zu bilden.

Wie zuvor bereits dargestellt ist, ergibt sich auf Grund der erfindungsgemäßen Grabengeometrie ein verbessertes Ätzverhalten beim Auftreffen der Ätzfront an der vergrabenen Isolationsschicht, so dass auch am Fuß der Isolationsstruktur das Silizium zuverlässig geätzt wird, so dass entsprechende Siliziumreste, wie sie bei konventionellen Techniken häufig entstehen, im Wesentlichen vollständig vermieden werden.

In einer weiteren vorteilhaften Ausgestaltung umfasst das Vorsehen des Isolationsgrabens das Ätzen eines Grabens in der aktiven Siliziumschicht mit Seitenwänden, die zumindest im Bereich der zu bildenden Vertiefung zumindest streckenweise schräg verlaufen und ferner umfasst das Vorsehen des Isolationsgrabens das Füllen des Grabens mit dielektrischem Material. Auf Grund der Grabengeometrie ergibt sich auch ein verbessertes Füllverhalten auf Grund der Reduzierung von Aufladungseffekten bei der Abscheidung des dielektrischen Materials mittels plasma-gestützter Abscheideverfahren.

Des weiteren ergibt - in Kombination mit der bis zum Boden zuverlässig ausgebildeten Seitenwänden der lsolationsstruktur - deren schräge Ausbildung einen zuverlässigen Siliziumabtrag während des gesamten Ätzvorgangs zur Erzeugung der Grube mit der aktiven Sensorstruktur, so dass damit insbesondere am Fuß der Isolationsstruktur das Silizium mit hoher Zuverlässigkeit entfernt wird.

Vorzugsweise wird beim Abscheiden zumindest an den Stellen mit nach unten zunehmender Breite ein Hohlraum erzeugt.

In weiteren vorteilhaften Ausführungsformen richtet sich die vorliegende Erfindung an SOI-Scheiben mit MEMS-Strukturen, Schaltungseinheiten und verfüllten Isolationsgräben zur dielektrischen Isolierung von Schaltungsteilen mit unterschiedlichen Potentialen, wobei die Isolationsgräben in von Silizium befreiten Gebieten bzw. Gruben, in deren Bereich sich die Sensorstrukturen befinden, enden, in diese hineinreichen oder diese durchlaufen. Dabei zeichnen sich die SOI-Scheiben dadurch aus, dass die Seitenwände der verfüllten Isolationsgräben in der Weise schräg gestaltet sind, dass sich der Isolationsgraben nach unten hin stetig verbreitert, d. h. ein A-Form besitzt.

In einer weiteren Ausführungsform endet der verfüllte Isolationsgraben mit einem definiert langen Stück stumpf in der zu ätzenden Grube mit der aktiven Sensorstruktur, wodurch das Freiätzen der Grabenverfüllung von beiden Längsseiten der Grabenverfüllung sowie von der Stirnseite aus erfolgt.

In einer weiteren Ausführungsform verläuft der verfüllte Isolationsgraben in einem kurzen Stück geradlinig durch die zu ätzende Grube mit der aktiven Sensorstruktur, wodurch das Freiätzen der Grabenverfüllung von zwei Seiten aus erfolgt und der verfüllte Isolationsgraben im nicht abgetragenen Siliziumgebiet endet.

In einer weiteren Ausführungsform verläuft der verfüllte Isolationsgraben in einem definierten Stück über Eck oder mäanderförmig durch die zu ätzende Grube bzw. Vertiefung mit der aktiven Sensorstruktur, wodurch das Freiätzen der Grabenverfüllung von zwei Seiten und an einer oder mehreren Ecken erfolgt.

In einer weiteren Ausführungsform sind die Isolationsgräben ausschließlich mit Siliziumdioxid gefüllt, wodurch sich die Grabenverfüllung in definierten Bereichen vollständig und ohne Kurzschlussgefahr entfernen lässt.

In einer noch weiteren Ausführungsform besitzen die Isolationsgräben nur in den Bereichen, die für die Bereiche der von Silizium freigeätzten Vertiefungen bzw. Gruben Bedeutung haben, einen A-förmigen Querschnitt.

Weitere vorteilhafte Ausführungsformen sind aus der Beschreibung von Beispielen ersichtlich, unter Bezug auf die beigefügten Figuren, zur Erläuterung und Ergänzung der beanspruchten Erfindungen.
- Figur 1: ist eine schematische Darstellung des Endes eines verfüllten, herkömmlichen und nicht beanspruchten Isolationsgrabens, bei dem auf einem kurzen Stück des verfüllten Isolationsgrabens das umgebende Silizium unvollständig entfernt ist.
- Figur 2: ist eine schematische Darstellung des Endes eines verfüllten erfindungsgemäßen Isolationsgrabens, bei dem auf einem kurzen Stück des verfüllten Isolationsgrabens das umgebende Silizium vollständig entfernt ist.
- Figur 3: ist eine schematische Querschnittsansicht entlang der Tiefe des verfüllten Isolationsgrabens an der Grenze zur Vertiefung im Silizium gemäß Figur 2.
- Figur 4: ist ein in Richtung des gleichen schematischen Querschnitts wie in Figur 3 durch das Ende des verfüllten Isolationsgrabens genommene Ansicht in dem Bereich, der in die Vertiefung mit der aktiven Sensorstruktur hineinragt.
- Figur 5: ist eine schematische Darstellung eines Ausschnitts des Layouts, wobei der verfüllte Isolationsgraben in der Vertiefung bzw. Grube mit der aktiven Sensorstruktur endet.
- Figur 6: ist eine schematische Darstellung eines Ausschnitts des Layouts, wobei die Verfüllung des Isolationsgrabens sich in der frei geätzten Grube bzw. Vertiefung mit der aktiven Sensorstruktur fortsetzt und diese auf geradem Wege durchläuft und in einem Siliziumgebiet endet.
- Figur 7: ist eine schematische Darstellung eines Ausschnitts des Layouts, wobei die Verfüllung des Isolationsgrabens die Vertiefung bzw. Grube mit der aktiven Sensorstruktur als vom Silizium freigelegte Grabenverfüllung auf einem abgewinkelten Weg (hier rechtwinklig abgewinkelt) durchläuft und in einem Siliziumgebiet endet.

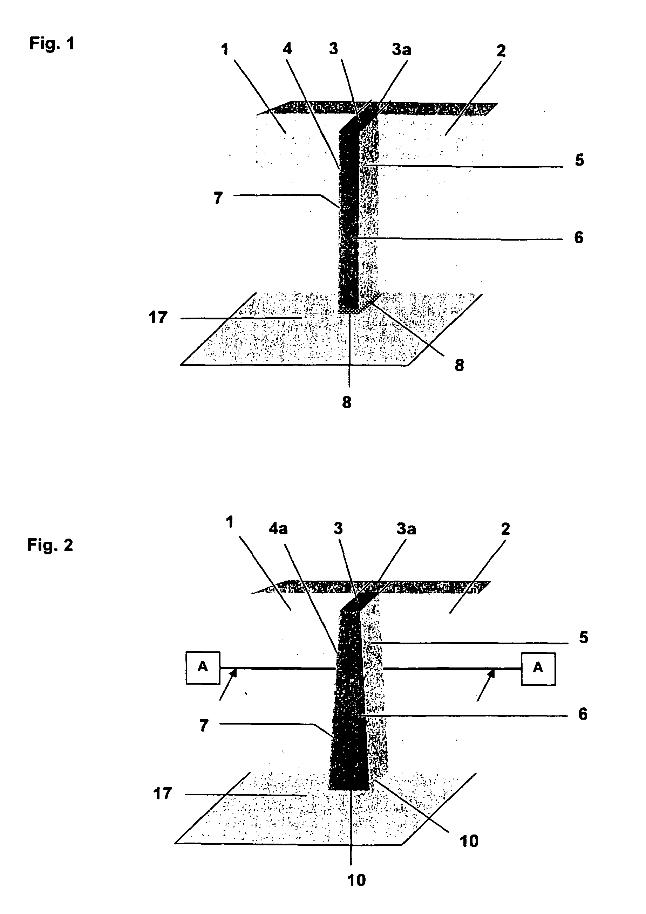

Mit Bezug zu Figur 1 sei hier zunächst noch einmal eine SOI MEMS-Struktur gezeigt, die nach konventioneller Technik hergestellt ist, und nicht beansprucht wird.

**Figur 1** zeigt eine herkömmliche Methode, um die Nachteile zu verdeutlichen, die durch die Erfindung überwunden werden. In Figur 1 ist ein freigelegtes Ende 3 der Verfüllung eines herkömmlichen Isolationsgrabens 3a gezeigt, so dass ein kurzes Stück in Fortsetzung des verfüllten Isolationsgrabens 3a in eine von Silizium befreite Grube bzw. Vertiefung 17 mit einer aktiven Sensorstruktur (nicht gezeigt) hineinragt. Das kurze Stück bzw. das Ende 3 des Isolationsgrabens 3a bzw. der Isolationsstruktur weist Seitenwände 5, 6 und 7 auf, die im Wesentlichen senkrecht ausgebildet sind, wie dies durch das Bezugszeichen 4 angedeutet ist. Die Seitenwände 5, 6 und 7 sind nahezu vollständig von Silizium befreit, wohingegen im Fußbereich des Endes 3 leitende Siliziumreste bzw. Streifen 8 in Bodennähe an den Seitenwänden der Verfüllung, auf einem vergrabenen Oxid aufsitzend verbleiben und dadurch eine elektrisch leitende Verbindung zwischen zu isolierenden benachbarten Siliziumgebieten 1 und 2 herstellen können.

Typischerweise wird die in Figur 1 gezeigte Struktur hergestellt, indem zunächst ein Graben zwischen den Gebieten 1 und 2 geätzt und anschließend mit einem geeigneten dielektrischen Material, etwa Siliziumdioxid gefüllt wird. Hierbei können sich insbesondere beim Verfüllen des Grabens, das typischerweise durch plasmaverstärkte chemische Dampfabscheidung erfolgt, insbesondere in Bodennähe durch Aufladungseffekte Störungen ergeben. Des weiteren wird beim anschließenden Ätzen zur Herstellung der Vertiefung 17 auf Grund der nahezu senkrechten Wände 4 ein vollständiger Abtrag des Siliziums in Bodennähe auf Grund von Aufladungseffekten während des Plasma-Ätzvorganges erschwert, so dass die leitenden Siliziumstreifen 8 verbleiben.

**Figur 2** zeigt eine entsprechende erfindungsgemäße SOI-Halbleiterstruktur, in der ein erstes Gebiet 1 von einem zweiten Gebiet 2 elektrisch mittels einer Isolationsstruktur 3a, die als Isolationsgraben ausgebildet ist, isoliert sind. Ferner weist die Isolationsstruktur 3a einen freistehenden Fortsatz 3 auf, der somit mit einer definierten Länge vom umgebenden Silizium freigeätzt ist. Der in eine Vertiefung 17 hineinreichende Fortsatz bzw. Teil 3 der Isolationsstruktur 3a besitzt Seitenwände 5, 6 und 7, wobei insbesondere die seitlichen Wände 5 und 7 einen schrägen Verlauf, der durch das Bezugszeichen 4a gekennzeichnet ist, so aufweisen, dass zumindest der Teil 3 sich nach unten hin verbreitert. Ferner ist in Figur 2 gezeigt, dass entsprechende Innenkanten bzw. Ecken 10 im Wesentlichen vollständig von Silizium frei sind und damit keine unerwünschten leitfähigen Siliziumstreifen aufweisen. In Figur 2 wird damit verdeutlicht, dass durch die erfinderische Geometrie, d. h. durch die A-Form des Grabenquerschnitts zumindest an dem Teil 3, das umgebende Silizium vollständig von Seitenwänden 5, 6 und 7 entfernt ist. Die Wände des verfüllten Isolationsgrabens 3a und des Endes 3 sind in dieser Ausführungsform nicht senkrecht (4a). Dadurch wird ein vollständiges Freiätzen im Bereich der Kante 10 erreicht, so dass eine dielektrische Isolierung der benachbarten Siliziumgebiete 1 und 2 gewährleistet ist.

Die in Figur 2 gezeigte SOI-Halbleiterstruktur lässt sich herstellen, indem ein geeignetes selektives Ätzrezept zur Erzeugung eines Grabens zwischen den Gebieten 1 und 2 ausgeführt wird, wobei beispielsweise eine entsprechend klein bemessene Ätzmaske verwendet wird und wobei im Laufe des Ätzens der Grad der Anisotropie, beispielsweise durch Steuerung der Vorspannung zwischen Plasma und Substrat, entsprechend eingestellt wird, so dass sich ein zunehmender Grad an "Isotropie" einstellt, der zu einer entsprechenden sich nach unten verbreiternden Geometrie des Grabens führt. Anschließend kann der entstandene Graben durch gut etablierte Abscheidetechniken, etwa plasmaunterstützte chemische Dampfabscheidung mit Siliziumdioxid verfüllt werden, wobei entsprechende Hohlräume entstehen können, wie dies nachfolgend beschrieben wird, um somit die Isolationsstruktur 3a zu bilden. Danach wird die Vertiefung 17 durch entsprechendes anisotropes selektives Ätzen gebildet, wobei auf Grund der erfindungsgemäßen Geometrie des Isolationsgrabens 3a bzw. zumindest des Teils 3 ein entsprechender vollständiger Abtrag des Siliziums an den Kanten 10 erreicht wird.

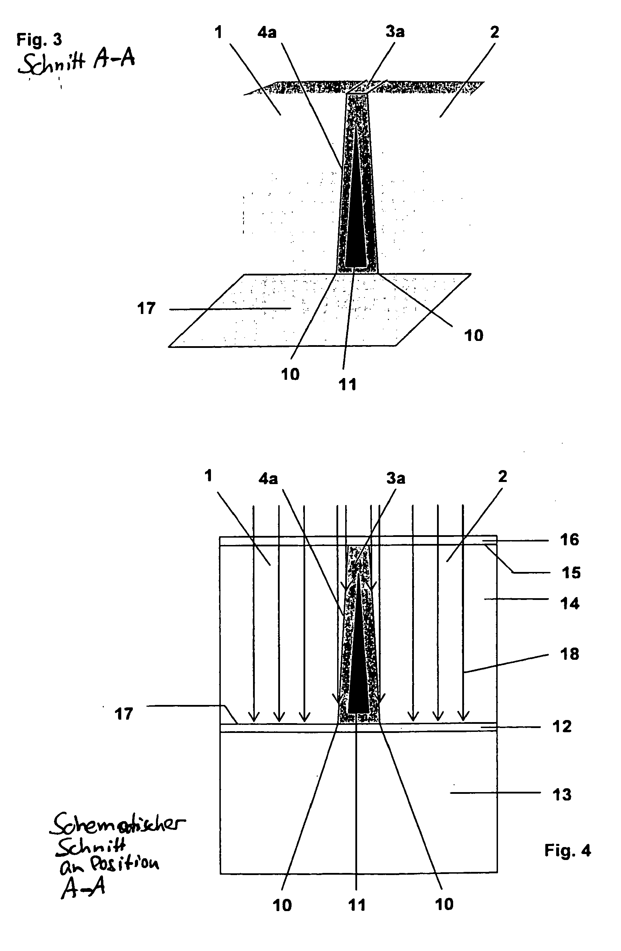

**Figur 3** ist ein Querschnitt durch die Isolationsstruktur 3a an der Grenze zu der Grube bzw. Vertiefung 17 gemäß der Schnittlinie A-A in Figur 2. Die benachbarten Siliziumgebiete 1 und 2 sind voneinander dielektrisch isoliert. Die Isolationsstruktur 3a weist einen verbleibenden Hohlraum 11 auf, der nach oben hin hermetisch dicht verschlossen ist. Auf Grund der schräg verlaufenden Seitenwände der Isolationsstruktur 3a und des Teiles 3, die mit 4a bezeichnet sind, bleiben keine ungewünschten leitenden Siliziumstreifen im Bereich der Innenkante/Ecke 10 zurück. Ferner dient der Hohlraum 11 dazu, entsprechende mechanische Spannungen aufzunehmen, so dass die in der Vertiefung 17 gebildeten aktiven Sensorstrukturen ein günstigeres Bauteilverhalten aufweisen können.

**Figur 4** ist der Querschnitt durch das nach der Ätzung stehen gebliebene Ende 3 der Isolationsstruktur 3a, das in die Vertiefung bzw. Grube 17 mit der aktiven Sensorstruktur hineinragt, wobei der Schnitt entsprechend der Linie A-A in Figur 2 erfolgt. Die Pfeile 18 repräsentieren einen anisotropen Ätzvorgang zum Freiätzen des kurzen Stücks 3 des verfüllten Isolationsgrabens 3a von umgebendem Silizium. Die benachbarten Siliziumgebiete 1 und 2 sind voneinander elektrisch isoliert. Die Isolationsstruktur 3a weist einen verbleibenden Hohlraum 11 auf, der nach oben hin hermetisch dicht verschlossen ist. Auf Grund der schrägen Seitenwände 4a des Endes 3 der Isolationsstruktur 3 bleiben nach der Ätzung keine Siliziumreste stehen und es ergibt sich der Bereich der Innenkante/Ecke 10 ohne ungewünschte leitende Siliziumstreifen.

Während des Ätzprozesses, der durch die Pfeile 18 dargestellt ist, wird mittels einer Ätzmaske 16 ein entsprechender Teil des SOI-Substrats freigelegt bzw. abgedeckt, so dass an den vorgesehenen Bereichen die Vertiefung 17 hergestellt werden kann. Der an der Siliziumoberfläche 15 beginnende anisotrope Ätzprozess 18 trägt das Silizium in Pfeilrichtung nach unten ab, wobei die nicht zu ätzenden Bereiche durch die Ätzmaske 16 geschützt sind. Wegen der Schräge der Seitenwände 4a findet im Verlauf des Ätzprozesses 18 ein kontinuierlicher Ätzangriff auf die Seitenwand der Isolationsstruktur 3a statt, so dass ein vollständiger Abtrag des diese Seitenwände der Isolationsstruktur 3a bedeckenden Siliziums möglich ist. Damit wird das umgebende Silizium sicher entfernt und es bleiben im Wesentlichen keine ungewünschten leitenden Siliziumstreifen an Stellen übrig, wie das ohne schräge Seitenwände durch Ausbleiben oder stark verzögernden Abtrag vor allem am Ende des Ätzprozesses kurz vor Erreichen des vergrabenen Oxids 12 der Fall ist. Die beim Freiätzen entstehende Vertiefung bzw. Grube 17 mit der aktiven Sensorstruktur im Silizium endet in vertikaler Richtung auf dem vergrabenen Oxid 12. Darunter befindet sich das Substrat 13.

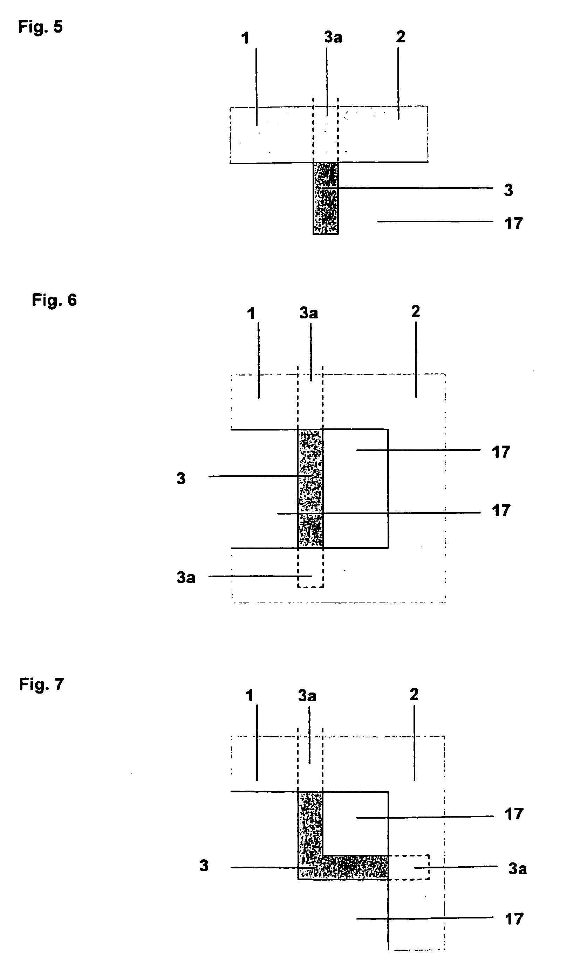

**Figur 5** zeigt schematisch eine Aufsicht auf eine geometrische Anordnung der Isolationsstruktur 3a mit einem entsprechenden Ende 3, das geradlinig in eine Vertiefung 17 mündet, wobei die Isolationsstruktur 3a entsprechende Siliziumgebiete 1 und 2 elektrisch voneinander isoliert.

**Figur 6** zeigt eine entsprechende Konfiguration, in der die Isolationsstruktur 3a die entsprechende Vertiefung 17 nahezu geradlinig durchläuft und wieder in der aktiven Siliziumschicht, die auch die Gebiete 1 und 2 trägt, mündet.

**Figur 7** zeigt eine entsprechende Anordnung, in der die Isolationsstruktur 3 in der Vertiefung 17 rechtwinklig angeordnet ist und jeweils in den entsprechenden Isolationsstrukturen 3a in der aktiven Siliziumschicht endet bzw. die entsprechenden Gebiete 1 und 2 elektrisch voneinander isoliert.

Eine Gestaltung von verfüllten Isolationsgeräten, insbesondere der Übergangsbereich in von Silizium freien Gebieten (z. B. Gruben und Vertiefungen), wird bei der Realisierung von MEMS-Strukturen auf SOI-Scheiben erreicht, wodurch eine sichere dielektrische Isolierung benachbarter Siliziumgebiete gewährleistet wird. Die Isolation wird durch verfüllte Isolationsgräben erreicht. Dabei kommt es darauf an, dass die vom umgebenden Silizium freigeätzten Fußbereiche der Grabenverfüllung in der Grube mit der aktiven Sensorstruktur frei von leitenden, nicht vollständig entfernten Siliziumstreifen sind. Dies wird durch hinterschnittene, d.h. schräge Wände der Isolationsgräben erreicht, so dass der Isolationsgraben zu seinem Fußbereich hin breiter wird. Zusätzlich kann die erfolgte Grabenverfüllung im Übergangsbereich leicht wieder entfernt werden. Die technologische Umsetzung erfordert keine speziellen zusätzlichen Arbeitsgänge.

## Patentansprüche

1. **SOI-Halbleiterstruktur** mit
- einem ersten Gebiet (1) und einem zweiten Gebiet (2),
- einer Isolationsstruktur (3a), die zwischen dem ersten und dem zweiten Gebiet (1,2) als Isolationsgraben zur elektrischen Isolierung des ersten Gebiets (1) von dem zweiten Gebiet (2) ausgebildet ist,
- wobei zumindest ein Teil (3) der Isolationsstruktur (3a) nach unten hin verbreitert ist.
- einer Vertiefung (17) mit einer Sensorstruktur,
- wobei der Teil zumindest in die Vertiefung hineinreicht.

2. SOI-Halbleiterstruktur nach Anspruch 1, wobei die Isolationsstruktur (3a,3) die Vertiefung durchläuft.

3. SOI-Halbleiterstruktur nach mindestens einem der Ansprüche 1 bis 2, wobei sich die Isolationsstruktur (3a,3) nach unten stetig verbreitert.

4. SOI-Halbleiterstruktur nach einem der Ansprüche 1 bis 3, wobei die Isolationsstruktur (3a,3) so mit einem dielektrischen Material gefüllt ist, dass zumindest abschnittsweise ein Hohlraum (11) im Inneren der Isolationsstruktur (3a,3) gebildet ist.

5. SOI-Halbleiterstruktur nach Anspruch 1, wobei der Teil (3) mit definierter Länge in die Vertiefung (17) hineinreicht.

6. SOI-Halbleiterstruktur nach Anspruch 1, wobei der Teil (3) der Isolationsstruktur (3a) geradlinig durch die Vertiefung (17) verläuft.

7. SOI-Halbleiterstruktur nach Anspruch 1, wobei der Teil (3) der Isolationsstruktur (3a) über Eck oder mäanderförmig durch die Vertiefung (17) verläuft.

8. SOI-Halbleiterstruktur nach mindestens einem der Ansprüche 1 bis 7, wobei die Isolationsstruktur (3a,3) mit Ausnahme von Hohlräumen (11) aus Siliziumdioxid gebildet ist.

9. SOI-Halbleiterstruktur nach Anspruch 1, wobei die Isolationsstruktur (3a,3) im wesentlichen nur in und an der Vertiefung (17) nach unten hin verbreitert ist.

10. Verfahren zum Ätzen zumindest einer Vertiefung (17) in eine aktive Siliziumschicht eines SOI-Substrats, mit den Schritten
- Bilden zumindest eines Isolationsgrabens (3a) in der aktiven Siliziumschicht, der sich bis zu einer vergrabenen Isolationsschicht (12) erstreckt und der zumindest in einem Bereich der zu bildenden Vertiefung (17) nach unten hin verbreitert ist,
- Selektives anisotropes Ätzen des Siliziums bis zu der vergrabenen Isolationsschicht (12), um die zumindest eine Vertiefung (17) zu bilden.

11. Verfahren nach Anspruch 10, wobei Bilden des Isolationsgrabens umfasst,
- Ätzen eines Grabens in die aktive Siliziumschicht mit Seitenwänden, die zumindest im Bereich der zu bildenden Vertiefung zumindest streckenweise schräg verlaufen, und
- Füllen des Grabens mit dielektrischem Material.

12. Verfahren nach Anspruch 11, wobei das Füllen so erfolgt, dass ein Hohlraum zumindest an den Stellen mit nach unten zunehmender Breite entsteht.

## Claims

1. SOI semiconductor structure comprising
- a first region (1) and a second region (2),
- an insulating structure (3a) which is formed between the first and the second region (1, 2) as an insulating trench for electrical insulation of the first region (1) from the second region (2),
- wherein at least one part (3) of the insulating structure (3a) is widened downwards,
- a depression (17) having a sensor structure,
- wherein the part extends at least into the depression.

2. SOI semiconductor structure according to claim 1, wherein the insulating structure (3a, 3) passes through the depression.

3. SOI semiconductor structure according to at least one of claims 1 to 2, wherein the insulating structure (3a, 3) is widened continuously downwards.

4. SOI semiconductor structure according to one of claims 1 to 3, wherein the insulating structure (3a, 3) is filled with a dielectric material so that at least in some sections a cavity (11) is formed in the interior of the insulating structure (3a, 3).

5. SOI semiconductor structure according to claim 1, wherein the part (3) having defined length extends into the depression (17).

6. SOI semiconductor structure according to claim 1, wherein the part (3) of the insulating structure (3a) runs in a straight line through the depression (17).

7. SOI semiconductor structure according to claim 1, wherein the part (3) of the insulating structure (3a) runs diagonally or in meander-like manner through the depression (17).

8. SOI semiconductor structure according to at least one of claims 1 to 7, wherein the insulating structure (3a, 3), with the exception of cavities (11), is formed from silicon dioxide.

9. SOI semiconductor structure according to claim 1, wherein the insulating structure (3a, 3) is widened downwards essentially only in and on the depression (17).

10. Process for etching at least one depression (17) into an active silicon layer of an SOI substrate, comprising the steps
- forming at least one insulating trench (3a) in the active silicon layer which extends as far as a buried insulating layer (12) and which is widened downwards at least in one area of the depression (17) to be formed,
- selective anisotropic etching of the silicon as far as the buried insulating layer (12) to form the at least one depression (17).

11. Process according to claim 10, wherein forming the insulating trench comprises,
- etching a trench into the active silicon layer with side walls which run at an angle at least in some places at least in the area of the depression to be formed, and
- filling the trench with dielectric material.

12. Process according to claim 11, wherein filling is effected so that a cavity is produced at least at the points having downwardly increasing width.

## Revendications

1. Structure de semi-conducteur SOI, avec
- une première zone (1) et une deuxième zone (2),
- une structure d'isolation (3a), qui est formée entre les première et deuxième zones (1,2) sous la forme d'une tranchée d'isolation pour l'isolation électrique de la première zone (1) par rapport à la deuxième zone (2),
- dans laquelle au moins une partie (3) de la structure d'isolation (3a) est élargie vers le bas,
- avec un creux (17) présentant une structure de capteur,
- dans laquelle la partie pénètre au moins partiellement dans le creux.

2. Structure de semi-conducteur SOI selon la revendication 1, dans laquelle la structure d'isolation (3a, 3) traverse le creux.

3. Structure de semi-conducteur SOI selon au moins une des revendications 1 et 2, dans laquelle la structure d'isolation (3a, 3) s'élargit en continu vers le bas.

4. Structure de semi-conducteur SOI selon au moins une des revendications 1 à 3, dans laquelle la structure d'isolation (3a, 3) est remplie d'un matériau diélectrique, de telle manière qu'une cavité (11) soit formée au moins par portions à l'intérieur de la structure d'isolation (3a, 3).

5. Structure de semi-conducteur SOI selon la revendication 1, dans laquelle la partie (3) pénètre dans le creux (17) avec une longueur définie.

6. Structure de semi-conducteur SOI selon la revendication 1, dans laquelle la partie (3) de la structure d'isolation (3a) s'étend en ligne droite à travers le creux (17).

7. Structure de semi-conducteur SOI selon la revendication 1, dans laquelle la partie (3) de la structure d'isolation (3a) s'étend en diagonale ou sous forme sinueuse à travers le creux (17).

8. Structure de semi-conducteur SOI selon au moins une des revendications 1 à 7, dans laquelle la structure d'isolation (3a, 3) est formée de dioxyde de silicium à l'exception des cavités (11).

9. Structure de semi-conducteur SOI selon revendication 1, dans laquelle la structure d'isolation (3a, 3) ne s'élargit vers le bas qu'essentiellement dans et sur le creux (17).

10. Procédé pour graver au moins un creux (17) dans une couche de silicium active d'un substrat SOI, comportant les étapes suivantes :
- formation d'au moins une tranchée d'isolation (3a) dans la couche de silicium active, qui s'étend jusqu'à une couche d'isolation enfouie (12) et qui s'élargit vers le bas au moins dans une région du creux à former (17),
- gravure anisotrope sélective du silicium jusqu'à la couche d'isolation enfouie (12), pour former l'au moins un creux (17).

11. Procédé selon la revendication 10, dans lequel la formation de la tranchée d'isolation comprend
- la formation d'une tranchée dans la couche de silicium active avec des parois latérales, qui s'étendent au moins par tronçons en oblique au moins dans la région du creux à former, et
- le remplissage de la tranchée avec un matériau diélectrique.

12. Procédé selon la revendication 11, dans lequel le remplissage est effectué de telle manière qu'il se forme une cavité au moins aux endroits présentant une largeur qui augmente vers le bas.
